# FASCICULE DE BREVET EUROPEEN

(11) **EP 4 548 385 B1**
(45) Date de publication et mention de la délivrance du brevet: **17.06.2026**
(21) Numéro de dépôt: 23729417.8
(22) Date de dépôt: 31.05.2023
(51) Int. Cl.: H10P 90/00, H10N 30/079, H10N 30/08, H10N 30/00

(54) **PROCÉDÉ DE FABRICATION D'UNE STRUCTURE COMPORTANT UNE COUCHE BARRIÈRE À LA DIFFUSION D'ESPÈCES ATOMIQUES**
VERFAHREN ZUR HERSTELLUNG EINER STRUKTUR MIT EINER BARRIERESCHICHT ZUR VERHINDERUNG DER DIFFUSION VON ATOMSPEZIES
METHOD FOR MANUFACTURING A STRUCTURE COMPRISING A BARRIER LAYER TO PREVENT DIFFUSION OF ATOMIC SPECIES

(30) Priorité: 29.06.2022 FR 2206501
(43) Date de publication de la demande: 07.05.2025
(73) Titulaire: SOITEC, 38190 Bernin (FR); Commissariat à l'Energie Atomique et aux Energies Alternatives, 75015 Paris (FR)
(72) Inventeur: MOUREY, Odile, 38190 BERNIN (FR); CAPELLO, Luciana, 38190 BERNIN (FR); HUYET, Isabelle, 38190 BERNIN (FR); KERDILES, Sébastien, 38054 GRENOBLE CEDEX 9 (FR); LEFORESTIER, Soazig, 38054 GRENOBLE CEDEX 9 (FR)
(74) Mandataire: IP Trust
(86) Numéro de dépôt international: PCT/EP2023/064571
(87) Numéro de publication internationale: WO 2024/002608

(56) Documents cités:
- WO-A1-2022/023630
- US-A1- 2018 114 720
- US-A1- 2018 158 721

## Description

### DOMAINE DE L'INVENTION

L'invention concerne un procédé de fabrication d'une structure comprenant une couche mince reportée sur un support muni d'une couche de piégeage de charges. L'invention trouve son application notamment dans les domaines de la microélectronique, des microsystèmes, de la photonique...

### ARRIERE PLAN TECHNOLOGIQUE DE L'INVENTION

Le document WO2021008742 rappelle qu'il est souvent avantageux de prévoir une couche de piégeage de charges électriques (plus concisément désignée « couche de piégeage » dans la suite de cette description) dans le support d'une structure formée d'une couche mince reportée, par l'intermédiaire d'une couche diélectrique, sur ce support. La fabrication de ce type de structure est par exemple décrite dans les documents FR2860341, FR2933233, FR2953640, US2015115480, US7268060 ou US6544656. Elle trouve notamment une application pour la formation de composants électroniques ou électroacoustiques dans le domaine des signaux radiofréquences (RF). Les documents US20180114720A1 et US20180158721A1 proposent également des structures de types « semiconducteur sur isolant » comprenant une couche de piégeage.

La couche mince, souvent monocristalline, peut être de nature semi-conductrice (par exemple du silicium - pour former une structure SOI, acronyme de « silicon on insulator » ou silicium sur isolant en français) ou isolante (par exemple un matériau piézoélectrique, tel que du tantalate de lithium ou du niobate de lithium, pour former une structure POI, acronyme de « Piezolectric on insulator » ou Piézoélectrique sur isolant en français).

Le document précité expose également que ce type de structure est particulièrement sensible à l'hydrogène, cette espèce atomique pouvant diffuser et se figer dans la couche de piégeage, ce qui tend à passiver les défauts électriques que cette couche comprend et, en conséquence, à dégrader les performances RF de la structure. Comme cela est documenté dans la publication « White paper - RF SOI Characterisation » de janvier 2015 et publié par la société SOITEC, la performance RF d'un substrat peut être caractérisée par une mesure de distorsion de seconde harmonique.

Il a été également observé que lorsque la couche mince comprenait du lithium, cette espèce atomique était également susceptible de diffuser dans la structure au cours des étapes de sa fabrication pour se figer dans la couche de piégeage et la doper. Tout comme pour l'hydrogène, la présence de lithium dans la couche de piégeage tend à dégrader les performances RF de la structure.

Pour prévenir la dégradation des performances RF engendrée par la diffusion d'espèces atomiques (notamment d'hydrogène) dans une structure comportant une couche de piégeage, les documents WO2021008742 et WO2022023630 proposent d'exploiter la couche diélectrique intercalaire pour lui procurer un effet barrière.

Les natures et les dimensions des différentes couches constituant une structure ne sont pas choisies librement. Elles sont généralement dictées par l'application visée et les caractéristiques des composants qui seront formés à l'aide de cette structure.

Ainsi, et à titre purement illustratif, la nature et l'épaisseur de la couche diélectrique d'une structure POI sont imposées par la performance attendue d'un filtre à onde élastique de surface formé sur la couche mince piézoélectrique. L'épaisseur de la couche de piégeage peut également affecter la propagation des ondes élastiques en surface de la couche mince, et son épaisseur peut également être imposée pour garantir le fonctionnement conforme du composant.

Or, dans certaines configurations de structure, l'effet barrière de la couche diélectrique proposée par les documents WO2021008742 et WO2022023630 peut ne pas être suffisant. C'est par exemple le cas lorsque la structure présente une couche de piégeage relativement peu épaisse, par exemple d'épaisseur inférieure à 0,5 micron. Dans un tel cas, les performances RF de la structure sont très sensibles à la migration d'espèces dans la couche de piégeage. Les pièges électriques sont en effet relativement peu nombreux dans cette couche, et une proportion importante de ces pièges peuvent être passivés par une faible quantité d'espèces piégées.

Lorsque la couche intercalaire diélectrique est de relativement faible épaisseur, par exemple inférieure à 200 nm, l'effet barrière de diffusion de cette couche est naturellement bien moins efficace, notamment vis-à-vis de la diffusion du lithium dans la structure.

Dans d'autres configurations, l'effet barrière conféré à la couche diélectrique peut imposer des contraintes de fabrication. Ainsi, lorsque la couche diélectrique intercalaire est d'épaisseur relativement importante, par exemple supérieure à 20 nm, cette couche peut introduire des contraintes dans la structure qui tendent à la déformer. Une structure excessivement déformée ne peut plus être manipulée et traitée par les équipements conventionnels dans le domaine de la microélectronique, ce qui complexifie énormément sa fabrication, voire l'en empêche.

La solution proposée par les documents WO2021008742 et WO2022023630 pour se prémunir de la diffusion d'espèces atomiques ne peut donc s'appliquer facilement pour une large gamme de dimensions et de nature des différentes couches constituant la structure.

### OBJET DE L'INVENTION

Un but de l'invention est d'améliorer cet état de la technique en proposant une structure incorporant une barrière de diffusion à certaines espèces atomiques, notamment d'hydrogène et/ou de lithium, dans une structure comprenant une couche de piégeage de charges. Plus particulièrement, un but de l'invention est de proposer une couche intercalaire diélectrique ayant un effet barrière à la diffusion et pouvant être employée dans une large gamme de dimension des différents éléments composant la structure.

### BREVE DESCRIPTION DE L'INVENTION

En vue de la réalisation de ce but, l'objet de l'invention propose un procédé de fabrication d'une structure comprenant une couche mince formée d'un matériau à base de lithium et reportée sur un support par l'intermédiaire d'une couche intercalaire diélectrique comprenant une première couche diélectrique, une couche barrière en nitrure de silicium et une deuxième couche diélectrique, le support comprenant une couche de piégeage de charges électriques disposée superficiellement, du côté de la couche mince, sur un substrat de base. Selon l'invention, le procédé comportant les étapes suivantes :
- former la première couche diélectrique sur la couche de piégeage disposée sur une face principale du support ;
- former la couche barrière en nitrure de silicium sur et en contact avec la première couche diélectrique et présentant une épaisseur au moins égale à 20 nm, comprise entre 20% et 30% d'une épaisseur de la couche intercalaire diélectrique;
- former la deuxième couche diélectrique sur et en contact avec la couche barrière ;
- assembler la face principale du support et une face principale d'un substrat donneur afin de constituer une structure intermédiaire;
- éliminer une partie du substrat donneur de la structure intermédiaire pour définir la couche mince (4) sur le support.

Selon d'autres caractéristiques avantageuses et non limitatives de l'invention, prises seules ou selon toute combinaison techniquement réalisable :
- le substrat donneur comprend un matériau piézoélectrique monocristallin ;
- le substrat donneur est muni, sur sa face principale et avant son assemblage au support, d'une couche diélectrique superficielle ;
- la première couche diélectrique et la deuxième couche diélectrique sont constituées d'oxyde de silicium ou d'oxynitrure de silicium ;
- la première couche diélectrique ou la deuxième couche diélectrique est constituée d'oxynitrure de silicium incorporant de l'azote dans un ratio azote/ oxygène inférieur à 0,5 ;
- la couche de piégeage est en silicium polycristallin ;
- la formation de la première couche diélectrique comprend l'oxydation de la couche de piégeage ;
- la première couche diélectrique et la deuxième couche diélectrique sont constituées d'oxynitrure de silicium incorporant de l'azote dans un ratio azote/oxygène variable et croissant en direction de la couche barrière ;
- l'empilement formé de la première couche diélectrique, de la couche barrière, et de la deuxième couche diélectrique est réalisé sur le support par dépôt « in situ » dans une chambre et selon une technique LPCVD.

Selon un autre aspect, l'objet de l'invention propose une structure comprenant un support formé d'une couche de piégeage de charges électriques disposée superficiellement sur un substrat de base et comprenant une couche mince formée d'un matériau à base de lithium et reportée sur le support, la structure comprenant une couche diélectrique intercalaire disposée entre et en contact avec le support et la couche mince.

Selon l'invention, la structure étant caractérisée en ce que la couche diélectrique intercalaire comprend :
a. une première couche diélectrique disposée sur et en contact avec la couche de piégeage ;
b. une couche barrière en nitrure de silicium disposée sur et en contact avec la première couche diélectrique et présentant une épaisseur au moins égale à 20 nm, comprise entre 20% et 30% d'une épaisseur de la couche intercalaire diélectrique ;
c. une deuxième couche diélectrique disposée sur et en contact avec la couche barrière.

Selon d'autres caractéristiques avantageuses et non limitatives de l'invention, prises seules ou selon toute combinaison techniquement réalisable :
- le substrat de base est un substrat de silicium monocristallin ;
- la couche de piégeage est en silicium polycristallin ;
- la couche de piégeage présente une épaisseur inférieure à 0,5 micron ;
- la couche mince est constituée d'un matériau piézoélectrique monocristallin ;
- la première couche diélectrique et la deuxième couche diélectrique sont constituées d'oxyde de silicium ou d'oxynitrure de silicium ;
- la première couche diélectrique et la deuxième couche diélectrique sont constituées d'oxynitrure de silicium incorporant de l'azote dans un ratio azote/oxygène variable et croissant en direction de la couche barrière ;
- la structure se présente sous la forme d'une plaquette de forme circulaire, présentant un diamètre inférieur ou égal à 200mm, et une courbure inférieure à 100 microns ;
- la couche diélectrique intercalaire présente une épaisseur supérieure à 200 nm ;
- la couche barrière est constituée d'un nitrure de silicium non stœchiométrique.

### BREVE DESCRIPTION DES FIGURES

D'autres caractéristiques et avantages de l'invention ressortiront de la description détaillée de l'invention qui va suivre en référence aux figures annexées sur lesquels :
[Fig.1] La [Fig.1] représente une structure conforme à l'invention ;
[Fig.2] La [Fig.2] représente une autre structure conforme à l'invention ;
[Fig.3] La [Fig.3] représente un procédé de fabrication d'une structure conforme à l'invention ;

### DESCRIPTION DETAILLEE DE L'INVENTION

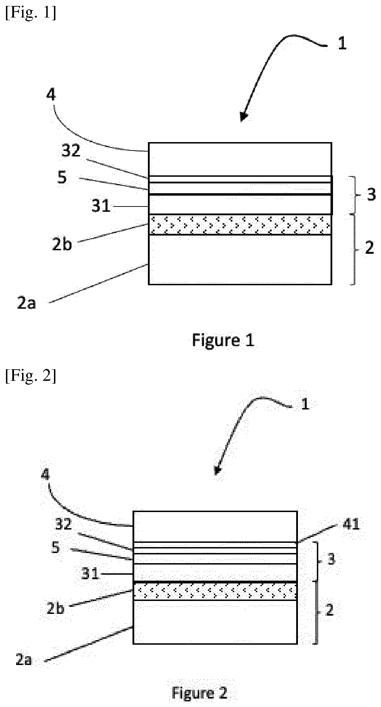

D'une manière très générale et en référence aux figures 1 et 2, la présente description porte sur une structure 1 et un procédé de fabrication de cette structure 1. La structure 1 comprend, successivement, une couche mince monocristalline 4, une couche diélectrique intercalaire 3 et un support 2. Le support 2 comprend lui-même un substrat de base 2a muni d'une couche de piégeage de charges électriques 2b. Sur les modes de mise en œuvre représentés sur les figures, la couche diélectrique intercalaire 3 est en contact avec la couche de piégeage 2b et avec la couche mince 4. Comme cela a été exposé dans l'introduction de cette demande, une telle structure 1 est particulièrement adaptée à recevoir, sur ou dans la couche mince 4, des composants radiofréquences (RF).

De manière conventionnelle, la structure 1 peut se présenter sous la forme d'une plaquette circulaire dont le diamètre peut être de 100, 150, 200, 300 voire même 450mm.

Le substrat de base 2a du support 2 sur lequel repose la couche de piégeage 2b présente typiquement une épaisseur de plusieurs centaines de microns. Préférentiellement, le substrat de base 2a présente une résistivité élevée, supérieure à 1000 ohms centimètres, et plus préférentiellement encore, supérieure à 2000 ohms centimètres. On limite de la sorte la densité des charges, trous ou électrons, qui sont susceptibles de se déplacer dans le substrat de base. Mais l'invention n'est pas limitée à un substrat de base 2a présentant une telle résistivité, et elle procure également des avantages de performance RF lorsque le substrat de base présente une résistivité plus conforme, de l'ordre de quelques centaines d'ohms centimètres, par exemple inférieur à 1000 ohm.cm, ou à 500 ohm.cm voire même à 10 ohm.cm.

Pour des raisons de disponibilité et de coût, le substrat de base 2a est préférentiellement en silicium monocristallin. Il peut s'agir par exemple d'un substrat de silicium CZ à faible teneur en oxygène interstitiel comprise entre 6 et 10 ppm, ou d'un substrat de silicium FZ qui présente notamment une teneur en oxygène interstitiel naturellement très faible (sous la limite de détection usuellement fixée à 10^16 cm^-3). Il peut également s'agir d'un substrat de silicium CZ présentant une quantité élevée d'oxygène interstitiel (désigné par l'expression « High Oi ») supérieure à 26 ppm. Le substrat de base 2a peut alternativement être formé d'un autre matériau : il peut s'agir par exemple de saphir, de verre, de quartz, de carbure de silicium... Dans certaines circonstances, et notamment lorsque la couche de piégeage 2b présente une épaisseur suffisante, par exemple supérieure à 30 microns, le substrat de base 2a peut présenter une résistivité standard, inférieure à 1 kohm.cm.

La couche de piégeage 2b peut être de nature très variée, ainsi que cela est reporté dans les documents formant l'état de la technique. D'une manière générale, il s'agit d'une couche non monocristalline présentant des défauts structurels tels que des dislocations, des joints de grains, des zones amorphes, des interstices, des inclusions, des pores... Ces défauts structurels forment des pièges pour les charges susceptibles de circuler dans le matériau, par exemple au niveau de liaisons chimiques non complètes ou pendantes. On prévient ainsi la conduction dans la couche de piégeage qui présente en conséquence une résistivité élevée.

Son épaisseur, notamment lorsqu'elle est formée sur un substrat de base 2a résistif, peut être comprise entre 0,1 µm à 3 µm. Mais d'autres épaisseurs inférieures ou supérieures à cet intervalle sont tout à fait envisageables, selon le niveau de performance RF attendu de la structure 1.

De manière avantageuse, et pour des raisons de simplicité de mise en œuvre, cette couche de piégeage 2b est formée d'une couche de silicium polycristallin. Elle peut également comprendre des couches, ou être formée entièrement, d'un alliage de silicium et de carbone. Cette couche de piégeage comprenant du silicium polycristallin peut être formée par dépôt sur le substrat de base 2a.

Afin de chercher à préserver la qualité polycristalline de cette couche au cours des traitements thermiques que peut subir la structure 1, on peut avantageusement prévoir une couche amorphe, en dioxyde de silicium par exemple, sur le substrat de base 2a avant le dépôt de la couche de piégeage 2b.

On peut alternativement former la couche de piégeage 2b par une implantation d'espèce relativement lourde, tel que de l'argon, dans une épaisseur superficielle du substrat de base 2a, afin d'y former les défauts structurels constituant les pièges électriques. On peut également former cette couche 2b par porosification d'une épaisseur superficielle du substrat de base 2a ou par toute autre méthode apte à former des défauts structurels dans une épaisseur superficielle du substrat de base 2a, ces défauts structurels étant aptes à piéger des charges électriques.

La couche mince 4 de la structure 1 peut être de toute nature qui convient, notamment d'un matériau monocristallin. Lorsque la structure 1 est destinée à recevoir des composants intégrés à semi-conducteur, la couche mince 4 peut être ainsi composée de silicium monocristallin, ou de tout autre matériau semi-conducteur monocristallin tel que du germanium, du silicium germanium du carbure de silicium. Lorsque la structure 1 est destinée à recevoir des filtres à onde élastique de surface, la couche mince 4 peut être composée d'un matériau piézoélectrique et/ou ferroélectrique, monocristallin, tel que du tantalate de lithium ou du niobate de lithium. La couche mince 4 peut également comprendre des composants intégrés finis ou semi-finis, initialement formés sur un substrat donneur et reportés sur le support 2 au cours de l'étape de fabrication de la structure 1. D'une manière générale, la couche mince peut présenter une épaisseur comprise entre 10nm et 10 microns, selon l'application envisagée de la structure 1 et les performances attendues des composants.

La couche diélectrique intercalaire 3 peut quant à elle présenter une épaisseur comprise entre 50nm et plusieurs microns, par exemple 5 microns ou plus.

Pour prévenir la diffusion de certaines espèces atomiques vers la couche de piégeage 2b, la structure 1 comprend une couche barrière 5 en nitrure de silicium disposée dans la couche diélectrique intercalaire 3. Par « nitrure de silicium » on désigne un nitrure dont la formule générale est de la forme SiₓN_{y}, constitué donc d'azote et de silicium dans des proportions qui peuvent être stoechiométrique (Si₃N₄) ou non.

Plus précisément, la couche diélectrique intercalaire 3 comprend, formées et disposées sur le support 2 :
- Une première couche diélectrique 31 disposée sur et en contact avec la couche de piégeage 2b ;
- une couche barrière 5 en nitrure de silicium sur et en contact avec la première couche diélectrique ;
- une deuxième couche diélectrique 32 sur et en contact avec la couche barrière 5.

Pour des raisons qui seront rendues apparentes à la lecture de la suite de cette description, et comme cela est apparent sur la [Fig.2], la couche diélectrique intercalaire 3 peut également comprendre, disposée entre la deuxième couche diélectrique 32 et la couche mince 4, une couche diélectrique superficielle 41. Cette couche diélectrique superficielle 41 est avantageusement en contact avec la couche mince 4 et avec la deuxième couche diélectrique 32, mais cette caractéristique n'est pas impérative, et l'on peut prévoir que la couche diélectrique intercalaire 3 comprend d'autres couches que la couche diélectrique superficielle 41, disposées entre la deuxième couche diélectrique 32 et la couche mince 4.

Les espèces atomiques susceptibles de diffuser vers la couche de piégeage 2b peuvent notamment provenir de la couche mince 4. Il peut dans ce cas s'agir, à titre d'exemple, de lithium, lorsque cette couche mince 4 est constituée de tantalate de lithium ou de niobate de lithium (ou plus généralement de tout matériau à base de lithium). En prévoyant une couche barrière 5 en nitrure de silicium apte à bloquer la diffusion, entre autres, du lithium entre la couche mince 4 et la couche de piégeage 2b, on évite la dégradation des performances RF de la structure 1. Pour que l'effet barrière soit effectif, notamment vis-à-vis d'espèces légères telles que le lithium, il est préférable que la couche barrière en nitrure de silicium 5 présente une épaisseur au moins égale à 20 nm. Il n'est en général pas nécessaire de prévoir une épaisseur supérieure à 70nm pour que l'effet barrière soit suffisant (vis-à-vis de la diffusion d'espèces légères telles que le lithium ou l'hydrogène), mais on peut néanmoins former une couche barrière 5 présentant une épaisseur supérieure à cette valeur de 70nm si d'autres bénéfices sont attendus ou si la structure 1 est particulièrement sensible à la migration de ces espèces, comme cela sera décrit dans une section suivante de cette description.

La deuxième couche diélectrique 32 et, si elle est présente, la couche diélectrique superficielle 41, sont prévues pour faciliter l'assemblage de la structure. Aussi ces couches sont avantageusement à base d'oxyde de silicium, car il s'agit de matériaux dont on connaît bien les propriétés adhésives et que l'on sait préparer pour cet assemblage (nettoyage, traitement d'activation...). Il n'est pas nécessaire que ces couches 32,41 soient épaisses pour remplir leur fonction d'adhésion au cours de la fabrication de la structure, et avantageusement leurs épaisseurs sont chacune comprises entre 5 nm et 30nm.

Enfin la première couche diélectrique 31 vient fournir l'épaisseur de diélectrique complémentaire à la deuxième couche diélectrique 32, à la couche barrière 5 et aux éventuelles autres couches diélectriques disposées sur la deuxième couche diélectrique 32, pour obtenir une couche diélectrique intercalaire 3 d'épaisseur choisie. On rappelle que cette couche diélectrique intercalaire 3 peut présenter une épaisseur comprise entre 50nm et plusieurs microns, aussi la première couche diélectrique 31 peut présenter une épaisseur comprise entre 20 nm et plusieurs microns. Cette première couche diélectrique 31 est avantageusement à base d'oxyde de silicium, par simplicité de mise en œuvre.

Les espèces atomiques susceptibles de migrer vers la couche de piégeage 2b peuvent également provenir de la couche diélectrique intercalaire 3 elle-même, ou de l'interface d'assemblage présente au niveau de la deuxième couche diélectrique 32. C'est notamment le cas lorsque la couche diélectrique intercalaire 3 est réalisée, au moins en partie, par des techniques de dépôt mettant en œuvre des traitements thermiques modérés, inférieurs à 650°C. Ces traitements ne permettent pas d'exodiffuser certaines espèces, telles que de l'hydrogène, de la couche déposée et celles-ci restent donc susceptibles de diffuser au cours des autres étapes de fabrication de la structure 1, vers la couche de piégeage 2b.

Pour se prémunir de la diffusion de ces espèces qui désorbent de la couche diélectrique intercalaire 3, notamment à partir de la première couche diélectrique 31 disposée sous la couche barrière 5, au plus proche de la couche de piégeage 2b, il peut être avantageux de choisir le matériau et la technique de formation de la première et de la deuxième couche diélectrique 31, 32 (et dans une moindre mesure, des couches éventuellement présentes entre la deuxième couche diélectrique 32 et la couche mince 4) pour qu'elles ne contiennent peu d'hydrogène ou qu'elle limite la diffusivité de cet hydrogène. C'est notamment le cas lorsque la couche diélectrique intercalaire 3 est relativement épaisse, d'une épaisseur supérieure ou égale à 200nm, conduisant à une première couche diélectrique 31 présentant une épaisseur typiquement supérieure à 100nm. C'est également le cas lorsque la couche de piégeage 2b est relativement peu épaisse, inférieure à 500nm. Dans ces deux cas, les performances RF de la structure 1 sont particulièrement sensibles à la diffusion d'hydrogène vers la couche de piégeage 2b, comme cela a été exposé en introduction de cette demande.

Pour former des couches diélectriques contenant peu d'hydrogène, on peut former ces couches par dépôt selon une technique LPCVD (acronyme de l'expression anglo-saxonne « Low Pressure Chemical Vapor Deposition » ou dépôt chimique en phase vapeur à pression sous atmosphérique) dans une gamme de température comprise entre 650°C et 850°C, et préférentiellement entre 700°C et 800°C. Pour ce qui concerne la première couche diélectrique 31 disposée directement sur la couche de piégeage 2b, on peut choisir de la former par oxydation thermique de cette couche de piégeage, lorsque cette couche est constituée de silicium. Pour former des couches diélectriques limitant la diffusivité de cet hydrogène, on peut prévoir d'y incorporer de l'azote (pour former une couche de SiON). Pour caractériser la proportion d'azote dans la couche, on pourra s'appuyer sur une mesure de son indice de réfraction qui évolue (à une longueur d'onde de 633m) entre 1,45 pour du SiO2 à 2,02 pour du Si3N4 (c'est-à-dire un nitrure de silicium stœchiométrique).

La proportion d'azote dans la couche de SiON pourra être choisie très librement et selon la limitation de la diffusivité attendue, étant entendue que plus cette proportion est importante, plus cette diffusivité est réduite. Si l'on ne souhaite pas modifier excessivement les propriétés acoustiques de ces couches par rapport à des couches formées d'oxyde de silicium (ce qui peut avoir une conséquence sur la performance de certains composants formés sur la structure 1, tel que des composants à onde élastique), il est préférable de limiter la proportion d'azote, par exemple pour que le ratio azote/ oxygène reste compris entre 0,01 et 0,5 ou entre 0,05 et 0,1.

La proportion d'azote dans la première couche diélectrique 31 et dans la deuxième couche diélectrique 32 peut être identique ou différente entre elles. Cette proportion peut être constante au sein de la couche ou varier. Dans un mode de réalisation, le ratio azote/oxygène est variable dans la première couche diélectrique 31 et dans la deuxième couche diélectrique 32, croissant en direction de la couche barrière 5.

On notera que certains diélectriques peuvent apporter une contrainte mécanique en compression sur le substrat sur lequel ils sont formés. C'est le cas de l'oxyde de silicium. D'autres diélectriques peuvent apporter une contrainte en tension, comme c'est le cas du nitrure de silicium. Ces contraintes peuvent conduire à la déformation du substrat (« bow » selon le terme anglo-saxon consacré).

Aussi, lorsque la première couche 31 et la deuxième couche 32 sont formées d'un matériau diélectrique apportant une contrainte mécanique en compression, par exemple à base d'oxyde de silicium, l'épaisseur de la couche barrière 5 en nitrure de silicium peut être ajustée pour compenser cette contrainte. On restera bien entendu au-dessus de l'épaisseur seuil de 20nm conférant à cette couche son effet barrière.

Ainsi, on choisira avantageusement l'épaisseur de la couche barrière en nitrure de silicium 5 pour qu'elle présente une épaisseur comprise entre 20% et 30% de l'épaisseur de la couche intercalaire diélectrique. C'est notamment le cas lorsque le reste de la couche intercalaire est formée d'oxyde de silicium ou d'oxynitrure de silicium avec un ratio azote/oxygène inférieur à 0,5 et/ou que cette couche intercalaire 3 présente une épaisseur supérieure à 100nm. Avec un tel choix, on peut limiter la déformation d'une structure 1 se présentant sous la forme d'une plaquette de forme circulaire, et un diamètre supérieur ou égal à 150mm, à moins de 60 microns. Pour une structure 1 se présentant sous la forme d'une plaquette circulaire de diamètre égale à 200 mm, la déformation peut être limitée à moins de 100 microns.

On notera que cette approche visant à ajuster l'épaisseur de la couche barrière 5 pour limiter la déformation de la structure 1 est particulièrement intéressante à exploiter lorsque la couche diélectrique intercalaire 3 est relativement épaisse, supérieure à 200nm. Dans un tel cas, les contraintes se développant dans la structure 1 peuvent être relativement importantes, et il devient intéressant de les compenser pour éviter la déformation excessive de la structure. On note également, que cette déformation est d'autant plus importante que la dimension de la structure est importante, par exemple le diamètre de la plaquette lorsque la structure prend la forme d'une plaquette circulaire.

Dans d'autre cas, notamment lorsque la couche diélectrique intercalaire 3 est relativement peu épaisse, par exemple inférieure à 200nm, on peut souhaiter limiter la contrainte apportée en tension par la couche barrière en nitrure de silicium 5. A cet effet, on peut prévoir de former cette couche barrière 5 d'un nitrure non stœchio-métrique, enrichi en Si par rapport à un nitrure de silicium stœchiométrique, de sorte à faire chuter sa tension. Ce type de nitrure voit son indice dépasser 2.02 à 633nm, tendant vers 2,1, 2,2 voire même 2,3.

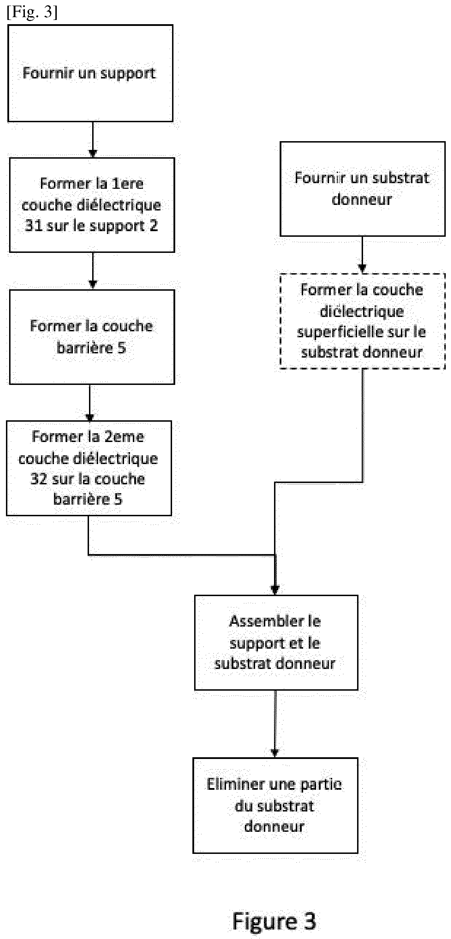

Très généralement, et en référence à la [Fig.3], la structure 1 peut être réalisée par un procédé de fabrication comprenant :
- la fourniture du support 2 comprenant une couche de piégeage de charges électriques 2b disposée superficiellement;
- la formation de la première couche diélectrique 31 sur une face dite « principale » du support 2 ;
- la formation de la couche barrière en nitrure de silicium 5 sur et en contact avec la première couche diélectrique 31 ;
- la formation de la deuxième couche diélectrique 32 sur et en contact avec la couche barrière 5 ;
- l'assemblage de la face principale du support et une face principale d'un substrat donneur afin de constituer une structure intermédiaire;
- l'élimination d'une partie du substrat donneur de la structure intermédiaire pour définir la couche mince 4 sur le support 2.

Ainsi, la première couche diélectrique 31, la couche barrière 5, la deuxième couche diélectrique 32 sont réalisées successivement sur le support 2. Comme on l'a précisé précédemment, l'épaisseur et/ou la stœchiométrie de la couche barrière 5 peut être ajustée pour limiter la déformation du support 2 après que celui-ci a reçu l'empilement. De cette manière, on facilite l'étape d'assemblage, car les faces principales du substrat donneur et du support sont planes ce qui favorise leur mise en contact intime.

Par « substrat donneur », on désigne un substrat constitué du matériau de la couche mince 4, ou comprenant une épaisseur superficielle en ce matériau. Ainsi, le substrat donneur peut, à titre d'exemple, être formé d'un substrat massif de silicium monocristallin, d'un substrat massif de tantalate de lithium ou de niobate de lithium, ou encore d'un substrat composite formé d'un premier substrat sur lequel repose une épaisseur (au moins égale à celle de la couche mince 4) de tantalate de lithium ou de niobate de lithium ou autres matériaux à base de Lithium.

Les couches diélectriques composant la couche diélectrique intercalaire 3 peuvent être réalisées par dépôt, par exemple selon une technique LPCVD (acronyme de l'expression anglo-saxonne « Low Pressure Chemical Vapor Deposition » ou dépôt chimique en phase vapeur à pression sous atmosphérique) ou PECVD (acronyme de l'expression anglo-saxonne « Plasma Enhanced Chemical Vapor Deposition » ou dépôt chimique en phase vapeur assisté par plasma). Comme on l'a déjà mentionné, la technique LPCVD peut être préférable en ce qu'elle tend à incorporer une quantité moindre d'hydrogène dans la couche formée que la technique PECVD.

La première couche diélectrique 31 et/ou la deuxième couche diélectrique 32 peuvent être constituées d'oxyde de silicium ou d'oxynitrure de silicium.

Lorsqu'il est réalisé par dépôt d'oxyde de silicium ou d'oxynitrure de silicium, cet empilement de couches peut être réalisé in situ, dans le même équipement de dépôt et sans extraire le support de l'équipement, ce qui forme une possibilité intéressante du point de vue de la cadence de fabrication.

Cette approche « in-situ » est particulièrement intéressante à exploiter lorsque la première couche diélectrique 31 et la deuxième couche diélectrique 32 sont constituées d'oxynitrure de silicium incorporant de l'azote dans un ratio azote/oxygène variable et croissant en direction de la couche barrière en nitrure de silicium 5. On peut maitriser l'incorporation d'azote dans l'équipement pour faire varier sa concentration au fur et à mesure de l'élaboration des différentes couches de l'empilement.

Une première couche diélectrique 31 en oxyde de silicium peut être alternativement obtenue par oxydation de la couche de piégeage 2b lorsque celle-ci est en silicium. Un tel traitement peut être mis en œuvre en exposant le support 2 muni de la couche de piégeage 2b dans un four d'oxydation à une température strictement comprise entre 700°C et 1000°C et dans une atmosphère riche en oxygène. Il peut s'agir d'une atmosphère sèche ou humide. Comme cela est bien connu en soi, la durée de cette exposition est choisie selon l'épaisseur désirée de la première couche diélectrique. On préférera généralement limiter la température d'oxydation à 900°C pour éviter tout risque de recristallisation de la couche de piégeage 2b. Dans cette approche, on fait préférablement suivre l'oxydation par une étape de polissage de la surface oxydée afin de faciliter l'assemblage ultérieur du substrat donneur et du substrat support 2.

Le substrat donneur peut être muni, sur sa face principale et avant son assemblage au support 2, d'une couche diélectrique superficielle 41. Comme on l'a déjà énoncé, la présence de cette couche diélectrique superficielle permet de faciliter l'étape suivante d'assemblage entre le substrat donneur et la deuxième couche diélectrique 32 présente sur le support 2.

L'étape d'assemblage est avantageusement mise en œuvre par adhésion moléculaire. Comme cela est bien connu en soi, au cours d'un procédé d'adhésion moléculaire, les surfaces exposées du support 2 (la deuxième couche diélectrique) et du substrat donneur (éventuellement formé de la couche diélectrique superficielle), parfaitement propres, planes et lisses, sont mises en contact intime l'une avec l'autre pour favoriser le développement de liaisons moléculaires, par exemple de type van der Waals ou co-valentes. L'assemblage des deux corps est alors obtenu sans utilisation d'un adhésif. Ces liaisons peuvent être renforcées par l'application d'un traitement thermique à la structure intermédiaire.

L'étape d'élimination d'une partie du substrat donneur peut être réalisée par amincissement mécano-chimique de ce substrat. Préférentiellement, la structure 1 est fabriquée par application de la technologie Smart Cut^{™}, selon laquelle une couche destinée à former la couche mince 4 est délimitée par l'intermédiaire d'un plan de fragilisation formé par implantation d'espèces légères (typiquement de l'hydrogène et/ou de l'hélium) dans le substrat donneur. Après l'étape d'assemblage, cette couche est prélevée du substrat donneur par fracture au niveau du plan de fragilisation et ainsi reportée sur le support 2.

Que l'élimination d'une partie de l'épaisseur du substrat donneur soit réalisée par amincissement ou par fracture, on peut appliquer à la structure 1 ainsi formée tout type de traitement de finition permettant de conformer la couche mince 4 à des spécifications d'épaisseur, d'uniformité d'épaisseur, de rugosité ou à tout autre type de spécifications.

Bien entendu l'invention n'est pas limitée au mode de mise en œuvre décrit et on peut y apporter des variantes de réalisation sans sortir du cadre de l'invention tel que défini par les revendications.

## Revendications

1. Procédé de fabrication d'une structure (1) comprenant une couche mince (4) formée d'un matériau à base de lithium et reportée sur un support (2) par l'intermédiaire d'une couche intercalaire diélectrique (3) comprenant une première couche diélectrique (31), une couche barrière en nitrure de silicium (5) et une deuxième couche diélectrique (32), le support comprenant une couche de piégeage de charges électriques (2b) disposée superficiellement, du côté de la couche mince (4), sur un substrat de base (2a), le procédé comportant les étapes suivantes :
- former la première couche diélectrique (31) sur la couche de piégeage (2b) disposée sur une face principale du support ;
- former la couche barrière en nitrure de silicium (5) sur et en contact avec la première couche diélectrique (31) et présentant une épaisseur au moins égale à 20 nm, comprise entre 20% et 30% d'une épaisseur de la couche intercalaire diélectrique (3) ;
- former la deuxième couche diélectrique (32) sur et en contact avec la couche barrière (5) ;
- assembler la face principale du support (2) et une face principale d'un substrat donneur afin de constituer une structure intermédiaire;
- éliminer une partie du substrat donneur de la structure intermédiaire pour définir la couche mince (4) sur le support (2).

2. Procédé de fabrication selon la revendication précédente dans lequel le substrat donneur comprend un matériau piézoélectrique monocristallin.

3. Procédé de fabrication selon l'une des revendications précédentes dans lequel la couche de piégeage (2b) est en silicium polycristallin.

4. Procédé de fabrication selon l'une des revendications précédentes dans lequel le substrat donneur est muni, sur sa face principale et avant son assemblage au support (2), d'une couche diélectrique superficielle (41).

5. Procédé de fabrication selon l'une des revendications précédentes dans lequel la première couche diélectrique (31) et la deuxième couche diélectrique (32) sont constituées d'oxyde de silicium ou d'oxynitrure de silicium.

6. Procédé de fabrication selon la revendication 5 dans lequel la première couche diélectrique (31) et la deuxième couche diélectrique (32) sont constituées d'oxynitrure de silicium incorporant de l'azote dans un ratio azote/oxygène variable et croissant en direction de la couche barrière (5).

7. Procédé de fabrication selon l'une des deux revendications précédentes dans lequel l'empilement formé de la première couche diélectrique (31), de la couche barrière (5), et de la deuxième couche diélectrique (32) est réalisé sur le support (2) par dépôt « in situ » dans une chambre et selon une technique LPCVD.

8. Procédé de fabrication selon l'une des revendications 1 à 6 dans lequel la formation de la première couche diélectrique (31) comprend l'oxydation de la couche de piégeage (2b).

9. Structure (1) comprenant un support (2) formé d'une couche de piégeage de charges électriques (2b) disposée superficiellement sur un substrat de base (2a) et comprenant une couche mince (4) formée d'un matériau à base de lithium et reportée sur le support (2), la structure (1) comprenant une couche diélectrique intercalaire (3) disposée entre et en contact avec le support (2) et la couche mince (4), la structure étant **caractérisée en ce que** la couche diélectrique intercalaire comprend :
a. une première couche diélectrique (31) disposée sur et en contact avec la couche de piégeage (2b) ;
b. une couche barrière (5) en nitrure de silicium disposée sur et en contact avec la première couche diélectrique (31) et présentant une épaisseur au moins égale à 20 nm, comprise entre 20% et 30% d'une épaisseur de la couche intercalaire diélectrique (3) ;
c. une deuxième couche diélectrique (32) disposée sur et en contact avec la couche barrière (5).

10. Structure (1) selon la revendication précédente dans laquelle la couche de piégeage (2b) est en silicium polycristallin.

11. Structure (1) selon l'une des revendications 9 à 10 dans laquelle la couche de piégeage (2b) présente une épaisseur inférieure à 0,5 micron.

12. Structure (1) selon l'une des revendications 9 à 11 dans laquelle la couche mince (4) est constituée d'un matériau piézoélectrique monocristallin.

13. Structure (1) selon l'une des revendications 9 à 12 dans laquelle la première couche diélectrique (31) et la deuxième couche diélectrique (32) sont constituées d'oxyde de silicium ou d'oxynitrure de silicium.

14. Structure (1) selon l'une des revendications 9 à 13 dans laquelle la première couche diélectrique (32) et la deuxième couche diélectrique (32) sont constituées d'oxynitrure de silicium incorporant de l'azote dans un ratio azote/oxygène variable et croissant en direction de la couche barrière (5).

15. Structure (1) selon l'une des revendications 9 à 14 se présentant sous la forme d'une plaquette de forme circulaire, présentant un diamètre inférieur ou égal à 200mm, et une courbure inférieure à 100 microns.

16. Structure (1) selon l'une des revendications 9 à 15 dans laquelle la couche diélectrique intercalaire (3) présente une épaisseur supérieure à 200 nm.

17. Structure (1) selon l'une des revendications 9 à 16 dans laquelle la couche barrière (5) est constituée d'un nitrure de silicium non stœchio-métrique.

## Patentansprüche

1. Verfahren zur Herstellung einer Struktur (1), die eine dünne Schicht (4) umfasst, die aus einem lithiumbasierten Material gebildet und auf einem Träger (2) über eine dielektrische Zwischenschicht (3) aufgebracht ist, die eine erste dielektrische Schicht (31), eine Barriereschicht aus Siliziumnitrid (5) und eine zweite dielektrische Schicht (32) umfasst, wobei der Träger eine Ladungsfangschicht (2b) umfasst, die oberflächlich auf einem Basissubstrat (2a) auf der Seite der dünnen Schicht (4) angeordnet ist, wobei das Verfahren die folgenden Schritte umfasst:
- Bilden der ersten dielektrischen Schicht (31) auf der Ladungsfangschicht (2b), die auf einer Hauptfläche des Trägers angeordnet ist;
- Bilden der Barriereschicht aus Siliziumnitrid (5) auf und in Kontakt mit der ersten dielektrischen Schicht (31), wobei sie eine Dicke von mindestens 20 nm aufweist, die zwischen 20% und 30% einer Dicke der dielektrischen Zwischenschicht (3) liegt;
- Bilden der zweiten dielektrischen Schicht (32) auf und in Kontakt mit der Barriereschicht (5);
- Zusammenfügen der Hauptfläche des Trägers (2) und einer Hauptfläche eines Spendersubstrats, um eine Zwischenstruktur zu bilden;
- Entfernen eines Teils des Spendensubstrats der Zwischenstruktur, um die dünne Schicht (4) auf dem Träger (2) zu definieren.

2. Verfahren zur Herstellung nach dem vorstehenden Anspruch, wobei das Spendersubstrat ein einkristallines piezoelektrisches Material umfasst.

3. Verfahren zur Herstellung nach einem der vorstehenden Ansprüche, wobei die Ladungsfangschicht (2b) aus polykristallinem Silizium besteht.

4. Verfahren zur Herstellung nach einem der vorstehenden Ansprüche, wobei das Spendersubstrat auf seiner Hauptfläche und vor dem Zusammenbau mit dem Träger (2) mit einer oberflächlichen dielektrischen Schicht (41) versehen ist.

5. Verfahren zur Herstellung nach einem der vorstehenden Ansprüche, wobei die erste dielektrische Schicht (31) und die zweite dielektrische Schicht (32) aus Siliziumoxid oder Siliziumoxynitrid bestehen.

6. Verfahren zur Herstellung nach Anspruch 5, wobei die erste dielektrische Schicht (31) und die zweite dielektrische Schicht (32) aus Siliziumoxynitrid bestehen, das Stickstoff in einem variablen und in Richtung der Barriereschicht (5) zunehmenden Stickstoff/Sauerstoff-Verhältnis enthält.

7. Verfahren zur Herstellung nach einem der beiden vorstehenden Ansprüche, wobei der aus der ersten dielektrischen Schicht (31), der Barriereschicht (5) und der zweiten dielektrischen Schicht (32) gebildete Stapel auf dem Träger (2) durch "in situ"-Abscheidung in einer Kammer und nach einer LPCVD-Technik hergestellt wird.

8. Verfahren zur Herstellung nach einem der Ansprüche 1 bis 6, wobei die Bildung der ersten dielektrischen Schicht (31) die Oxidation der Ladungsfangschicht (2b) umfasst.

9. Struktur (1), die einen Träger (2) umfasst, der aus einer Ladungsfangschicht (2b) gebildet ist, die oberflächlich auf einem Basissubstrat (2a) angeordnet ist, und eine dünne Schicht (4) umfasst, die aus einem lithiumbasierten Material gebildet und auf den Träger (2) aufgebracht ist, wobei die Struktur (1) eine dielektrische Zwischenschicht (3) umfasst, die zwischen und in Kontakt mit dem Träger (2) und der dünnen Schicht (4) angeordnet ist, wobei die Struktur **dadurch gekennzeichnet ist, dass** die dielektrische Zwischenschicht Folgendes umfasst:
a. eine erste dielektrische Schicht (31), die auf und in Kontakt mit der Ladungsfangschicht (2b) angeordnet ist;
b. eine Barriereschicht (5) aus Siliziumnitrid, die auf und in Kontakt mit der ersten dielektrischen Schicht (31) angeordnet ist und eine Dicke von mindestens 20 nm aufweist, die zwischen 20% und 30% einer Dicke der dielektrischen Zwischenschicht (3) liegt;
c. eine zweite dielektrische Schicht (32), die auf der Barriereschicht (5) angeordnet ist und mit ihr in Kontakt steht.

10. Struktur (1) nach dem vorstehenden Anspruch, bei der die Ladungsfangschicht (2b) aus polykristallinem Silizium ist.

11. Struktur (1) nach einem der Ansprüche 9 bis 10, bei der die Ladungsfangschicht (2b) eine Dicke von weniger als 0,5 Mikrometer aufweist.

12. Struktur (1) nach einem der Ansprüche 9 bis 11, bei der die dünne Schicht (4) aus einem monokristallinen piezoelektrischen Material besteht.

13. Struktur (1) nach einem der Ansprüche 9 bis 12, bei der die erste dielektrische Schicht (31) und die zweite dielektrische Schicht (32) aus Siliziumoxid oder Siliziumoxynitrid bestehen.

14. Struktur (1) nach einem der Ansprüche 9 bis 13, bei der die erste dielektrische Schicht (32) und die zweite dielektrische Schicht (32) aus Siliziumoxynitrid bestehen, das Stickstoff in einem variablen und in Richtung der Barriereschicht (5) zunehmenden Stickstoff/Sauerstoff-Verhältnis einschließt.

15. Struktur (1) nach einem der Ansprüche 9 bis 14, die in Form eines kreisförmigen Wafers vorliegt, mit einem Durchmesser von höchstens 200 mm und einer Krümmung von weniger als 100 Mikrometern.

16. Struktur (1) nach einem der Ansprüche 9 bis 15, bei der die dielektrische Zwischenschicht (3) eine Dicke von mehr als 200 nm aufweist.

17. Struktur (1) nach einem der Ansprüche 9 bis 16, bei der die Barriereschicht (5) aus einem nichtstöchiometrischen Siliziumnitrid besteht.

## Claims

1. A method for manufacturing a structure (1) comprising a thin layer (4) formed of a lithium-based material and transferred to a support (2) via a dielectric interlayer (3) comprising a first dielectric layer (31), a silicon nitride barrier layer (5) and a second dielectric layer (32), the support comprising an electrical charge trapping layer (2b) superficially disposed, on the side of the thin layer (4), on a base substrate (2a), the method comprising the following steps of:
- forming the first dielectric layer (31) on the trapping layer (2b) disposed on a main face of the support;
- forming the silicon nitride barrier layer (5) on and in contact with the first dielectric layer (31) and having a thickness at least equal to 20 nm, between 20% and 30% of a thickness of the dielectric interlayer (3);
- forming the second dielectric layer (32) on and in contact with the barrier layer (5);
- assembling the main face of the support (2) and a main face of a donor substrate in order to constitute an intermediate structure;
- removing part of the donor substrate from the intermediate structure to define the thin layer (4) on the support (2).

2. The manufacturing method according to the preceding claim, wherein the donor substrate comprises a single crystal piezoelectric material.

3. The manufacturing method according to one of the preceding claims, wherein the trapping layer (2b) is of polycrystalline silicon.

4. The manufacturing method according to one of the preceding claims, wherein the donor substrate is provided, on its main face and before it is assembled to the support (2), with a superficial dielectric layer (41).

5. The manufacturing method according to one of the preceding claims, wherein the first dielectric layer (31) and the second dielectric layer (32) are made of silicon oxide or silicon oxynitride.

6. The manufacturing method according to claim 5, wherein the first dielectric layer (31) and the second dielectric layer (32) consist of silicon oxynitride incorporating nitrogen in a variable nitrogen/oxygen ratio increasing in the direction of the barrier layer (5).

7. The manufacturing method according to one of the two preceding claims, wherein the stack formed of the first dielectric layer (31), the barrier layer (5), and the second dielectric layer (32) is made on the support (2) by "in situ" deposition in a chamber and according to an LPCVD technique.

8. The manufacturing method according to one of claims 1 to 6, wherein forming the first dielectric layer (31) comprises oxidising the trapping layer (2b).

9. A structure (1) comprising a support (2) formed of an electrical charge trapping layer (2b) superficially disposed on a base substrate (2a) and comprising a thin layer (4) formed of a lithium-based material and transferred to the support (2), the structure (1) comprising a dielectric interlayer (3) disposed between and in contact with the support (2) and the thin layer (4), the structure being **characterised in that** the dielectric interlayer comprises:
a. a first dielectric layer (31) disposed on and in contact with the trapping layer (2b) ;
b. a silicon nitride barrier layer (5) disposed on and in contact with the first dielectric layer (31) and having a thickness of at least 20 nm, between 20% and 30% of a thickness of the dielectric interlayer (3);
c. a second dielectric layer (32) disposed on and in contact with the barrier layer (5).

10. The structure (1) according to the preceding claim, wherein the trapping layer (2b) is of polycrystalline silicon.

11. The structure (1) according to one of claims 9 to 10, wherein the trapping layer (2b) has a thickness of less than 0.5 micron.

12. The structure (1) according to one of claims 9 to 11, wherein the thin layer (4) consists of a single crystal piezoelectric material.

13. The structure (1) according to one of claims 9 to 12, wherein the first dielectric layer (31) and the second dielectric layer (32) consist of silicon oxide or silicon oxynitride.

14. The structure (1) according to one of claims 9 to 13, wherein the first dielectric layer (32) and the second dielectric layer (32) consist of silicon oxynitride incorporating nitrogen in a variable nitrogen/oxygen ratio increasing in the direction of the barrier layer (5).

15. The structure (1) according to one of claims 9 to 14, having the form of a circular-shaped wafer, having a diameter less than or equal to 200 mm, and a curvature less than 100 microns.

16. The structure (1) according to one of claims 9 to 15, wherein the dielectric interlayer (3) has a thickness larger than 200 nm.

17. The structure (1) according to one of claims 9 to 16, wherein the barrier layer (5) consists of a non-stoichiometric silicon nitride.
